# EUROPEAN PATENT SPECIFICATION

(11) **EP 3 471 139 B1**
(45) Date of publication and mention of the grant of the patent: **24.11.2021**
(21) Application number: 18198225.7
(22) Date of filing: 02.10.2018
(51) Int. Cl.: H01L 23/40

(54) **MOUNTING DEVICE ON A CIRCUIT BOARD AND METHOD FOR MOUNTING AN OBJECT ON A CIRCUIT BOARD**
MONTAGEVORRICHTUNG AUF EINER LEITERPLATTE SOWIE VERFAHREN ZUM BEFESTIGEN EINES GEGENSTANDES AUF EINER LEITERPLATTE
DISPOSITIF DE MONTAGE SUR UNE CARTE DE CIRCUIT IMPRIMÉ ET PROCÉDÉ DE MONTAGE D'UN OBJET SUR UNE CARTE DE CIRCUIT IMPRIMÉ

(30) Priority: 13.10.2017 TW 106135080
(43) Date of publication of application: 17.04.2019
(73) Proprietor: Pegatron Corporation, Taipei City (TW)
(72) Inventor: TSAI, Wen-Sheng, TAIPEI CITY (TW); TSAO, Wei-Chun, TAIPEI CITY (TW); YEN, Pei-Shu, TAIPEI CITY (TW)
(74) Representative: Becker & Kurig Partnerschaft Patentanwälte PartmbB

(56) References cited:
- WO-A1-2014/073528
- US-A- 5 122 480
- US-A1- 2002 114 137

## Description

### 1. Field of the Invention

The present invention relates to a mounting device on a circuit board and a mounting method for mounting an object on a circuit board, especially to a mounting device and a mounting method for mounting a heat sink on a circuit board.

### 2. Description of the Prior Arts

In electronic products, various components are mounted on a circuit board. For instance, a heat sink may be mounted on a circuit board and abut a top surface of a central processing unit (hereinafter referred to as CPU) for heat dissipation. Precisely, there are mainly two conventional mounting approaches of mounting the heat sink on the circuit board. However, the conventional mounting approaches have the following shortcomings: the grounding of the heat sink is rather bad or does not even work; the mounting strength is insufficient; the components are hard to assemble; the cost is high.

US 5 122 480 A discloses a heat sink/electromagnetic shield assembly for a circuit element disposed upon a circuit board. A spring clip containing at least one hooked projection forming the spring is positioned in a confronting relationship with the circuit element. A U-shaped housing is slidingly positioned over the circuit element and the spring clip to enclose the circuit element and to compress the hooked projection which forms the spring. Compression of the hooked projection causes the hooked projection to exert a spring force to retain the housing in position about the circuit element. The assembly may be constructed in-line during construction of the electrical circuit disposed upon the circuit board.

To overcome the shortcomings, the present invention provides a mounting device on a circuit board according to claim 1 and a method for mounting an object on a circuit board according to claim 7 to mitigate or obviate the aforementioned problems.

The main objective of the present invention is to provide a mounting device on a circuit board for mounting an object on the circuit board, wherein the object has a through hole and the circuit board has at least one plated hole, and the mounting device has a good grounding.

The mounting device comprises a penetrating portion, an abutting portion, and a pin portion. The penetrating portion is configured to pass through the through hole of the object. The abutting portion is disposed on one end of the penetrating portion and is capable of abutting an edge of an opening of the through hole of the object. The pin portion is disposed on another end of the penetrating portion opposite the abutting portion, and the pin portion comprises at least one pin configured to pass through the at least one plated hole and be soldered in the at least one plated hole of the circuit board. The penetrating portion comprises two surfaces, a groove recessed on one of the surfaces of the penetrating portion, and a protrusion protruding out of the other surface of the penetrating portion. The groove and the protrusion extend to the pin portion, and the groove and the protrusion correspond to each other in location.

A mounting method for mounting an object on a circuit board is also provided. The mounting method includes mounting at least one mounting device on the circuit board, passing the penetrating portion of the at least one mounting device through a through hole of the object, bending the abutting portion of the at least one mounting device to abut the edge of the opening of the through hole of the object, and thereby mounting the object on the circuit board via the at least one mounting device. The penetrating portion comprises two surfaces, a groove recessed on one of the surfaces of the penetrating portion, and a protrusion protruding out of the other surface of the penetrating portion. The groove and the protrusion extend to the pin portion, and the groove and the protrusion correspond to each other in location.

As the mounting device is made of a conductive metal and the pin passes through and is soldered in the plated hole of the circuit board, the object is electrically connected to the circuit board and thereby is grounded. Besides, a contact area between the pin and the plated hole is larger than that of a conventional retaining clip, so the grounding is improved. Furthermore, the mounting device in accordance with the present invention is soldered with the circuit board so the mounting strength is strong and stable. Since the mounting device is metal, it does not get embrittled due to the heat. On the other hand, when an object is fixed by multiple mounting devices in accordance with the present invention, the mounting devices can be mounted on any part of the object rather than be restricted to diagonal corners of the object. Thus, the shape of the object is not restricted to rectangle. Since the mounting strength is strong and stable the object do not need other components to improve mounting, which simplifies the mounting method and decrease the expense. Last but not least, in a conventional manufacturing process of electronic products, the circuit board may pass through a soldering oven or undergo spot welding; in the mounting method in accordance with the present invention, the mounting device may be soldered and mounted on the circuit board during the same soldering process so the mounting method is more simplified and efficient.

Other objectives, advantages and novel features of the invention will become more apparent from the following detailed description when taken in conjunction with the accompanying drawings.

### IN THE DRAWINGS

Fig. 1 is an exploded perspective view of a mounting device in accordance with the present invention;
Figs. 2 to 5 are serial operational views of a mounting method in accordance with the present invention;
Fig. 6 is a sectional view of the mounting device in Fig. 1, a circuit board, and an object after assembled;
Fig. 7 is an enlarged view of the mounting device, the circuit board, and the object in Fig. 6; and
Fig. 8 is a flow chart of the mounting method in Figs. 2 to 5.

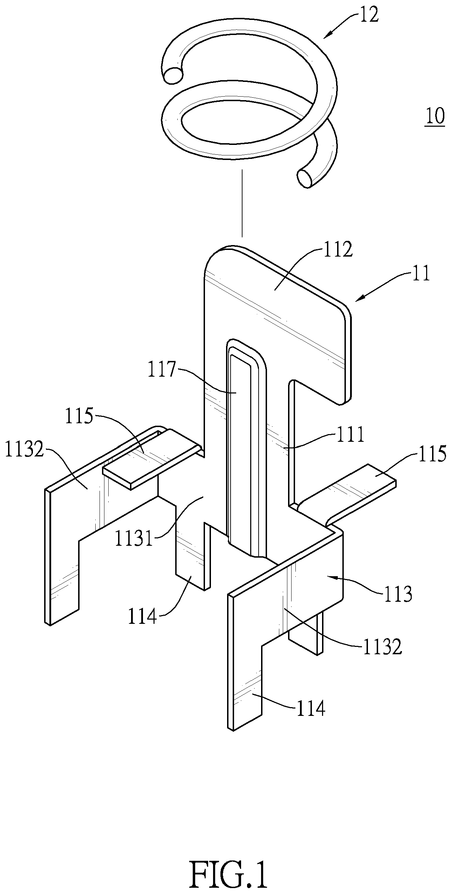

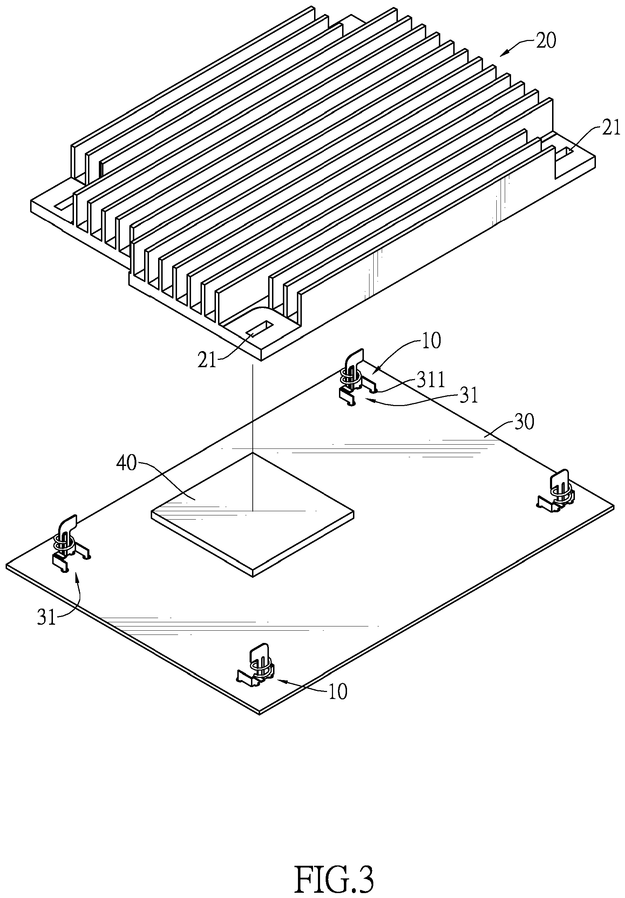

With reference to Fig. 1 and Fig. 3, a mounting device 10 on a circuit board 30 in accordance with the present invention is used for mounting an object 20 on the circuit board 30.

Please refer to Fig. 3, the object 20 has multiple through holes 21 for receiving the multiple said mounting devices 10 of the present invention mounted therein. In this embodiment, each one of the through holes 21 is rectangular but it is not limited thereto, and the through holes 21 may be in other shapes as long as they are suitable for the mounting device 10. Besides, in this embodiment, the object 20 may be a heat sink, but it is not limited thereto and may be other components.

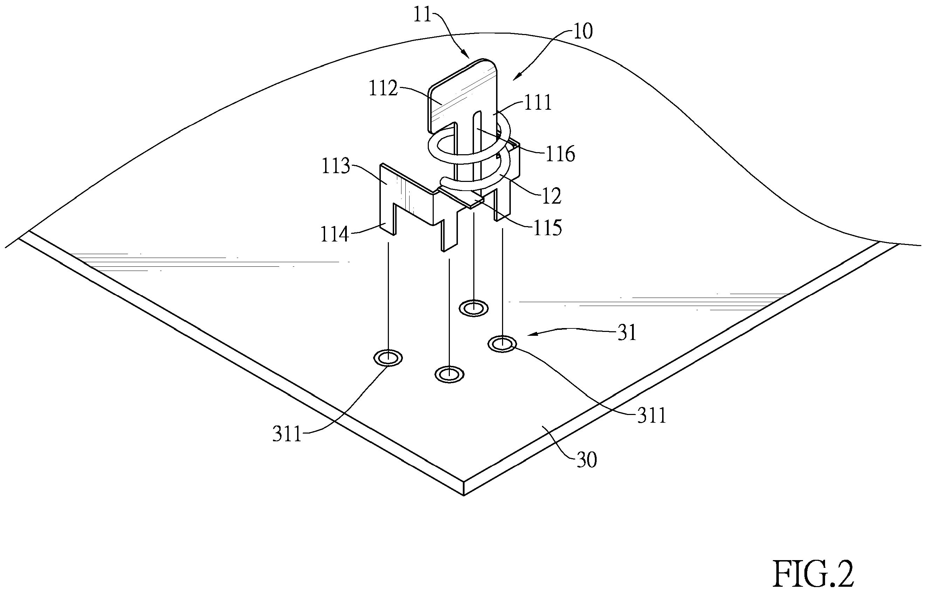

Then please refer to Fig. 2 and Fig. 3. The circuit board 30 has multiple plated hole groups 31 for receiving the multiple said mounting devices 10 of the present invention mounted therein. Each plated hole group 31 has at least one plated hole 311 (e.g. plating Through Hole aka PTH). In other words, the plated hole 311 is a hole plated with copper or other conductive material on a wall of the hole. In this embodiment, each plated hole group 31 includes four plated holes 311 matching the number of pins 114 of each mounting device 10, but it is not limited thereto. In another embodiment, each plated hole group 31 may only have one plated hole 311.

Then please refer to Fig. 1, Fig. 2, and Fig. 7. The mounting device 10 comprises a main body 11 and an elastic component 12.

The main body 11 is made of conductive metal and comprises a penetrating portion 111, an abutting portion 112, and a pin portion 113. In this embodiment, the main body 11 is a folded metal strip, which is easy to manufacture in mass production and decreases the cost. However, it is not limited thereto, and the main body 11 may be assembled through a plurality of components.

The penetrating portion 111 is configured to pass through one of the through holes 21 of the object 20. The abutting portion 112 is disposed at one end of the penetrating portion 111. In this embodiment, the abutting portion 112 is formed on a top end of the penetrating portion 111. The abutting portion 112 is capable to abut an edge of an opening of the through hole 21 of the object 20. In this embodiment, the abutting portion 112 is a flat piece and perpendicular to the penetrating portion 111, and protrudes outward from a lateral side of the penetrating portion 111. Therefore, after the rectangular through hole 21 of the objects 20 is passed through by the abutting portion 112 and the said object sits on the penetrating portion 111 through the through hole 21, a user may bend the abutting portion 112 with a horizontal force till an end of the abutting portion 112 abuts the edge of the opening of the through hole 21 of the object 20. However, the shape and the operation of the abutting portion 112 are not limited thereto as long as the abutting portion 112 is capable of abutting the edge of the opening of the through hole 21 of the object 20.

The pin portion 113 is mounted at another end of the penetrating portion 111, the said end being an end opposite the end mounted with the abutting portion 112. In this embodiment, the pin portion 113 is formed at a bottom end of the penetrating portion 111. In this embodiment, the pin portion 113 comprises a first extending portion 1131 and two second extending portions 1132. The first extending portion 1131 is formed below the penetrating portion 111 and a width of the first extending portion 1131 is larger than that of the penetrating portion 111. The two second extending portions 1132 are bent and formed at two respective ends of the first extending portion 1131.

In addition, the pin portion 113 further comprises four pins 114 and two support portions 115. The four pins 114 protrude out of a bottom side of the pin portion 113 and individually correspond to the four plated holes 311 of the plated hole group 31 of the circuit board 30. Each of the pins 114 passes through and is soldered in the corresponding plated hole 311. The number of the pins 114 corresponds the number of the plated holes 311 of each one of the plated hole groups 31. In another embodiment, the main body 11 may only have one pin 114 and each of the plated hole groups 31 may only have one plated hole 311. In this embodiment, each of the pins 114 is soldered when the circuit board 30 is passing through a solder oven in a process of a dual in-line package (hereinafter referred to as DIP), which simplifies the assembling process. With the aforesaid process, the number of the pins 114 is preferably larger than three for better mounting. The soldering process of the pins 114 and the plated holes 311 are not limited thereto and may be soldered with another approach.

The two support portions 115 are individually formed on a top side of the pin portion 113 and extend toward two opposite directions. In this embodiment, the two support portions 115 are formed on a top side of the first extending portion 1131 and the penetrating portion 111 is between the two support portions 115.

Besides, in this embodiment, the penetrating portion 111 forms a groove 116 and a protrusion 117 on two opposite surfaces thereof. The groove 116 and the protrusion 117 extend downward to the pin portion 113 and correspond to each other in location. Precisely, the groove 116 and the protrusion 117 are made by stamping the penetrating portion 111 and the pin portion 113, thereby increasing the strength of the penetrating portion 111 and the pin portion 113.

The elastic component 12 is sleeved on the main body 11 and has two ends. One end (e.g. top end) of the elastic component 12 pushes the object 20 in a direction away from the circuit board 30. In this embodiment, the elastic component 12 is a compression spring and is sleeved on the penetrating portion 111. The other end (e.g. bottom end) of the elastic component 12 opposite the object 20 abuts the two support portions 115. With the top end of the elastic component 12 pushing the object 20 upwards, the elastic component 12 is capable of repelling the object 20 away from the circuit board 30 so that the object 20 does not press other components (e.g. CPU) between the circuit board 30 and the object 20 nor damage those components, but it is not limited thereto. In another embodiment, the mounting device may not have the elastic component 12. In still another embodiment, the elastic component 12 may not be a compression spring as long as the elastic component 12 can be disposed on the main body 11 and push the object 20 upwards.

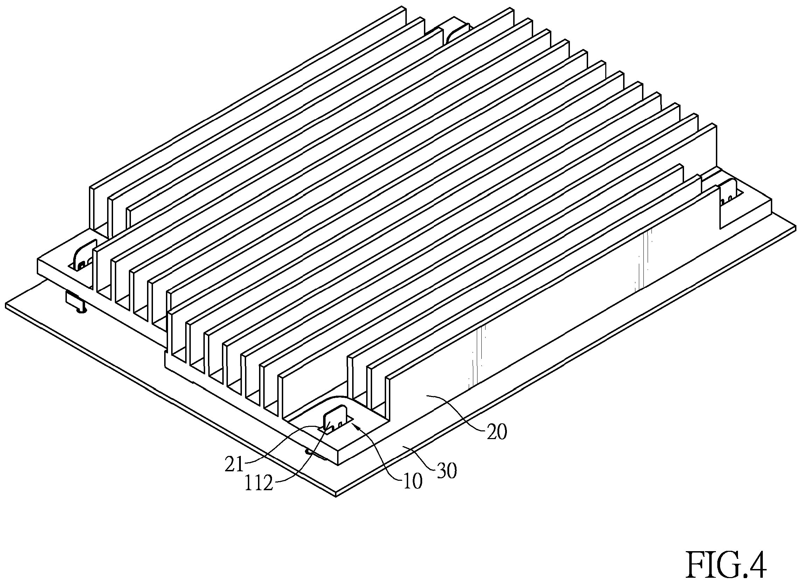

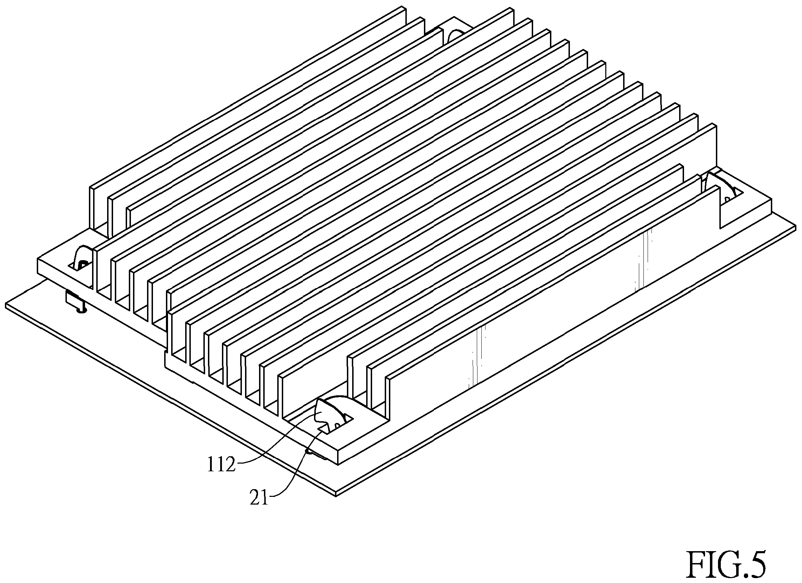

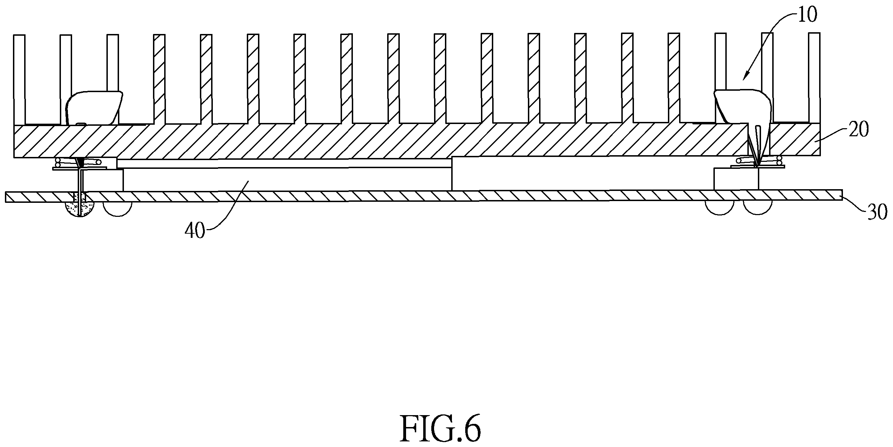

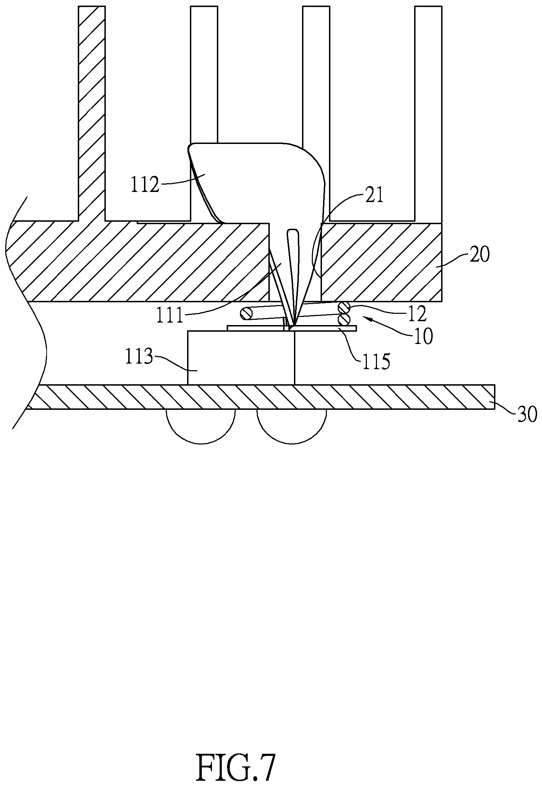

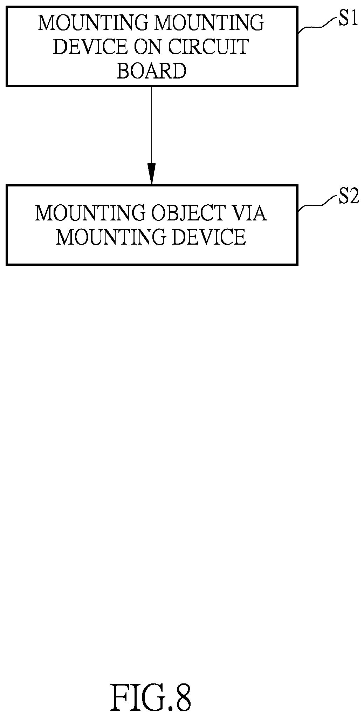

Then refer to Fig. 8. A mounting method in accordance with the present invention for mounting the object on the circuit board includes the following steps:
S1: MOUNTING A MOUNTING DEVICES ON A CIRCUIT BOARD: As shown in Fig. 2 and Fig. 3, mount the multiple said mounting devices on the circuit board 30. In this embodiment, the mounting devices are the mounting device 10 in accordance with the present invention as an exemplary demonstration, but it is not limited thereto, which means the mounting device may have different structures. Then, make each of the pins 114 of the mounting devices 10 pass through and soldered in the corresponding plated hole 311 of the plated hole group 31 of the circuit board 30. The soldering method of the pins 114 and the plated holes 311 can be executed when the circuit board 30 is passing through the solder oven under DIP at the same time as described above, but it is not limited thereto.
S2: MOUNTING AN OBJECT VIA THE MOUNTING DEVICE: As shown in Fig. 4 to Fig. 7, pass the mounting devices 10 through the through holes 21 of the object 20 and thus the object 20 presses the elastic components 12 of the mounting devices 10. In this embodiment, the through holes 21 are rectangular, allowing the rectangular abutting portion 112 of the mounting devices 10 to pass through and then the through holes 21 are penetrated by the penetrating portion 111 of the corresponding mounting device 10. Then, as shown in Fig.7, while the elastic components 12 is slightly compressed, the abutting portion 112 is bent with a horizontal force till the end of the abutting portion 112 abuts the edge of the opening of the corresponding through hole 21 of the object 20. Thus, the object 20 is clamped and mounted between the abutting portion 112 and the elastic component 12, i.e. mounted on the circuit board 30 which is soldered with the aforesaid mounting devices 10. After all of the abutting portions 112 of the mounting devices 10 are bent, the object 20 is mounted on the circuit board 30 thoroughly.

In this embodiment, the abutting portions 112 are bent with a horizontal force to abut the edges of the through holes 21 of the object 20, but it is not limited thereto. For example, the abutting portions 112 may be bent downward to abut the edges of the through holes 21 and thereby the object 20 is also mounted. In addition, the abutting method is not limited to a horizontal force or a downward force, as long as the abutting portions 112 can pass through the through holes 21 of the object 20 and the abutting portions 112 can abut the edges of the through holes 21.

In this embodiment, each of the mounting devices 10 has the elastic component 12 adapted for the objects 20 with various thicknesses. Besides, by the elastic component 12 pushing the object 20 away from the circuit board 30, the object 20 does not compress other components (e.g. CPU) between the circuit board 30 and the object 20. In another embodiment, the object 20 is clamped between the abutting portion 112 and the pin portion 113 without the elastic component 12.

When the present invention is utilized for a device with wireless communication function, e.g. when a CPU 40 or DDR is mounted on a circuit board 30, the object 20 is grounded via the main body 11 and the circuit board 30 because the main body 11 is made of a conductive metal and the pins 114 of the main body 11 are mounted and soldered in the plated hole 311 of the circuit board 30. Therefore, noise may not be radiated by the object 20 (e.g. a heat sink), and interference is decreased and the signal reception is improved.

Moreover, because the mounting device 10 and the circuit board 30 are soldered together, the mounting strength is strong. In the process of mounting the mounting devices 10 on the circuit board 30, tin may be plated on the circuit board 30 directly when the circuit board 30 is passing through the solder oven under DIP. During installation of the object 20 on the mounting devices 10, the abutting portions 112 may just be bent when the object 20 sits on the mounting devices 10, so the installation is very convenient. The main body 11 of the mounting device 10 is made of a folded metal strip and may be manufactured by computerized numerical control machine, so the cost is low.

In this embodiment, the multiple said mounting devices 10 are mounted on the circuit board 30, and the object 20 comprises the multiple said through holes 21, but the configurations are not limited thereto. In another embodiment, the object 20 may have only one through hole 21 so that it can be mounted by one mounting device 10.

## Claims

1. A mounting device (10) for mounting an object (20) on a circuit board (30), wherein the object (20) has a through hole (21) and the circuit board (30) has at least one plated hole (311); the mounting device (10) comprising:
a penetrating portion (111) configured to pass through the through hole (21) of the object (20) and having two ends; the penetrating portion (111) comprising:
two surfaces;
a groove (116) recessed on one of the surfaces of the penetrating portion (111); and
a protrusion (117) protruding out of the other surface of the penetrating portion (111);
an abutting portion (112) disposed on one of the ends of the penetrating portion (111) and being capable of abutting an edge of an opening of the through hole (21) of the object (20); and
a pin portion (113) disposed on the other end, opposite the abutting portion (112), of the penetrating portion (111), the pin portion (113) comprising:
at least one pin (114) configured to pass through the at least one plated hole (311) of the circuit board (30) and be soldered in the at least one plated hole (311), the mounting device (10) being **characterized in that**
the groove (116) and the protrusion (117) extend to the pin portion (113), and the groove (116) and the protrusion (117) correspond to each other in location.

2. The mounting device (10) as claimed in claim 1, wherein the penetrating portion (111), the abutting portion (112), and the pin portion (113) are made of a bent metal strip.

3. The mounting device (10) as claimed in claim 1 or 2, wherein the abutting portion (112) is a flat piece and perpendicular to the penetrating portion (111), and extends and protrudes from a side of the penetrating portion (111).

4. The mounting device (10) as claimed in claim 1 or 2 further comprising:
an elastic component (12) sleeved on the penetrating portion (111), the elastic component (12) having two ends and one of the two ends of the elastic component (12) being capable of pushing the object (20) away from the circuit board (30).

5. The mounting device (10) as claimed in claim 4, wherein the pin portion (113) further comprises:
two support portions (115) formed on a top of the pin portion (113), extending toward two opposite directions, and abutted by the other end, opposite the object (20), of the elastic component (12).

6. The mounting device (10) as claimed in claim 1 or 2, wherein the pin portion (113) comprises:
a first extending portion (1131) mounted on the penetrating portion (111) and a width of the first extending portion (1131) being larger than a width of the penetrating portion (111); wherein the two support portions (115) are bent and formed at the first extending portion (1131);
two second extending portions (1132) bent and respectively formed at two ends of the first extending portion (1131); wherein the number of the at least one pin (114) of the pin portion (113) is more than one, and two of the at least one pin (114) are individually mounted on the two second extending portions (1132).

7. A mounting method for mounting an object (20) on a circuit board (30) including the following steps:
mounting at least one mounting device (10) on the circuit board (30), wherein each of the at least one mounting device (10) comprises a penetrating portion (111), an abutting portion (112), and a pin portion (113), the abutting portion (112) and the pin portion (113) are disposed at two opposite ends of the penetrating portion (111), and the pin portion (113) comprises at least one pin (114) passing through the at least one plated hole (311) of the circuit board (30) and soldered in the at least one plated hole (311); the penetrating portion (111) comprises two surfaces, a groove (116), and a protrusion (117); the groove (116) is recessed on one of the surfaces of the penetrating portion (111); the protrusion (117) protrudes out of the other surface of the penetrating portion (111); and
passing the penetrating portion (111) of the at least one mounting device (10) through a through hole (21) of the object (20), bending the abutting portion (112) to abut an edge of an opening of the through hole (21) of the object (20), and thereby mounting the object (20) on the circuit board (30) via the at least one mounting device (10) the method being **characterized in that**
the groove (116) and the protrusion (117) extend to the pin portion (113), and the groove (116) and the protrusion (117) correspond to each other in location.

8. The mounting method as claimed in claim 7, wherein the mounting method further comprises: after the at least one mounting device (10) passes through the through hole (21), bending the abutting portion (112) of the at least one mounting device (10) with a horizontal force till the abutting portion (112) abuts the edge of the opening of the at least one through hole (21) of the object (20).

9. The mounting method as claimed in claim 7 or 8, wherein each of the at least one mounting device (10) comprises an elastic component (12) pushing the object (20) away from the circuit board (30).

10. The mounting method as claimed in claim 7 or 8, wherein the mounting method further comprises, after the at least one pin (114) of each of the at least one mounting device (10) passes through the at least one plated hole (311) of the circuit board (30), passing the circuit board (30) through a solder oven with the object (20) to solder the at least one pin (114) in the at least one plated hole (311).

## Patentansprüche

1. Befestigungsvorrichtung (10) zum Befestigen eines Gegenstands (20) auf einer Leiterplatte (30), wobei der Gegenstand (20) ein Durchgangsloch (21) aufweist und die Leiterplatte (30) mindestens ein plattiertes Loch (311) aufweist; wobei die Befestigungsvorrichtung (10) umfasst:
einen durchdringenden Abschnitt (111), der konfiguriert ist, dass er durch das Durchgangsloch (21) des Gegenstands (20) hindurchgeht, und der zwei Enden aufweist; wobei der durchdringende Abschnitt (111) umfasst:
zwei Oberflächen;
eine Nut (116), die auf einer der Oberflächen des durchdringenden Abschnitts (111) ausgespart ist; und
einen Vorsprung (117), der aus der anderen Fläche des durchdringenden Abschnitts (111) herausragt;
einen Anliegeabschnitt (112), der an einem der Enden des durchdringenden Abschnitts (111) angeordnet ist und in der Lage ist, an einem Rand einer Öffnung des Durchgangslochs (21) des Gegenstands (20) anzuliegen; und
einen Stiftabschnitt (113), der an dem anderen Ende, gegenüberliegend dem Anliegeabschnitt (112) des durchdringenden Abschnitts (111) angeordnet ist, wobei der Stiftabschnitt (113) umfasst:
mindestens einen Stift (114), der konfiguriert ist, dass er durch das mindestens eine plattierte Loch (311) der Leiterplatte (30) hindurchgeht und in dem mindestens einen plattierten Loch (311) verlötet ist, wobei die Befestigungsvorrichtung (10) **dadurch gekennzeichnet ist, dass**
die Nut (116) und der Vorsprung (117) sich bis zu dem Stiftabschnitt (113) erstrecken und die Nut (116) und der Vorsprung (117) einander in ihrer Lage entsprechen.

2. Befestigungsvorrichtung (10) gemäß Anspruch 1, wobei der durchdringende Abschnitt (111), der Anliegeabschnitt (112) und der Stiftabschnitt (113) aus einem gebogenen Metallstreifen hergestellt sind.

3. Befestigungsvorrichtung (10) gemäß Anspruch 1 oder 2, wobei der Anliegeabschnitt (112) ein flaches Stück ist und senkrecht zu dem durchdringenden Abschnitt (111) steht und sich von einer Seite des durchdringenden Abschnitts (111) aus erstreckt und vorsteht.

4. Befestigungsvorrichtung (10) gemäß Anspruch 1 oder 2, die ferner umfasst:
ein elastisches Bauteil (12), das auf den durchdringenden Abschnitt (111) aufgeschoben ist, wobei das elastische Bauteil (12) zwei Enden aufweist und eines der beiden Enden des elastischen Bauteils (12) in der Lage ist, den Gegenstand (20) von der Leiterplatte (30) wegzudrücken.

5. Befestigungsvorrichtung (10) gemäß Anspruch 4, wobei der Stiftabschnitt (113) ferner umfasst:
zwei Stützabschnitte (115), die an einer Oberseite des Stiftabschnitts (113) ausgebildet sind, sich in Richtung von zwei entgegengesetzten Richtungen erstrecken und an dem anderen Ende, gegenüberliegend dem Gegenstand (20), des elastischen Bauteils (12) anliegen.

6. Befestigungsvorrichtung (10) gemäß Anspruch 1 oder 2, wobei der Stiftabschnitt (113) umfasst:
einen ersten Erstreckungsabschnitt (1131), der an dem durchdringenden Abschnitt (111) befestigt ist, und eine Breite des ersten Erstreckungsabschnitts (1131) größer ist als eine Breite des durchdringenden Abschnitts (111); wobei die beiden Stützabschnitte (115) gebogen sind und an dem ersten Erstreckungsabschnitt (1131) ausgebildet sind;
zwei zweite Erstreckungsabschnitte (1132), die gebogen sind und jeweils an zwei Enden des ersten Erstreckungsabschnitts (1131) ausgebildet sind; wobei die Anzahl des mindestens einen Stifts (114) des Stiftabschnitts (113) mehr als eins beträgt und zwei des mindestens einen Stifts (114) einzeln an den zwei zweiten Erstreckungsabschnitten (1132) befestigt sind.

7. Befestigungsverfahren zum Befestigen eines Gegenstands (20) auf einer Leiterplatte (30), das die folgenden Schritte einschließt:
Befestigen mindestens einer Befestigungsvorrichtung (10) auf der Leiterplatte (30), wobei jede der mindestens einen Befestigungsvorrichtung (10) einen durchdringenden Abschnitt (111), einen Anliegeabschnitt (112) und einen Stiftabschnitt (113) aufweist, wobei der Anliegeabschnitt (112) und der Stiftabschnitt (113) an zwei gegenüberliegenden Enden des durchdringenden Abschnitts (111) angeordnet sind, und der Stiftabschnitt (113) mindestens einen Stift (114) aufweist, der durch das mindestens eine plattierte Loch (311) der Leiterplatte (30) hindurchgeht und in das mindestens eine plattierte Loch (311) gelötet ist; wobei der durchdringende Abschnitt (111) zwei Oberflächen, eine Nut (116) und einen Vorsprung (117) umfasst; wobei die Nut (116) auf einer der Flächen des durchdringenden Abschnitt (111) ausgespart ist; wobei der Vorsprung (117) aus der anderen Fläche des durchdringenden Abschnitts (111) vorsteht; und
Durchführen des durchdringenden Abschnitts (111) der mindestens einen Befestigungsvorrichtung (10) durch ein Durchgangsloch (21) des Gegenstands (20), Biegen des Anliegeabschnitts (112), so dass er an einem Rand einer Öffnung des Durchgangslochs (21) des Gegenstands (20) anliegt, und dadurch Befestigen des Gegenstands (20) auf der Leiterplatte (30) über die mindestens eine Befestigungsvorrichtung (10), wobei das Verfahren **dadurch gekennzeichnet ist, dass**
die Nut (116) und der Vorsprung (117) sich zu dem Stiftabschnitt (113) erstrecken und die Nut (116) und der Vorsprung (117) einander in ihrer Lage entsprechen.

8. Befestigungsverfahren gemäß Anspruch 7, wobei das Befestigungsverfahren ferner umfasst: nachdem die mindestens eine Befestigungsvorrichtung (10) durch das Durchgangsloch (21) hindurchgeht, Biegen des Anliegeabschnitts (112) der mindestens einen Befestigungsvorrichtung (10) mit einer horizontalen Kraft, bis der Anliegeabschnitt (112) an den Rand der Öffnung des mindestens einen Durchgangslochs (21) des Gegenstands (20) anliegt.

9. Befestigungsverfahren gemäß Anspruch 7 oder 8, wobei jede der mindestens einen Befestigungsvorrichtung (10) ein elastisches Bauteil (12) umfasst, das den Gegenstand (20) von der Leiterplatte (30) wegdrückt.

10. Befestigungsverfahren gemäß Anspruch 7 oder 8, wobei das Befestigungsverfahren ferner umfasst, dass, nachdem der mindestens eine Stift (114) jeder der mindestens einen Befestigungsvorrichtung (10) durch das mindestens eine plattierte Loch (311) der Leiterplatte (30) hindurchgeht, die Leiterplatte (30) mit dem Gegenstand (20) durch einen Lötofen geführt wird, um den mindestens einen Stift (114) in dem mindestens einen plattierten Loch (311) zu löten.

## Revendications

1. Dispositif de montage (10) pour monter un objet (20) sur une carte de circuit imprimé (30), dans lequel l'objet (20) possède un trou traversant (21) et la carte de circuit imprimé (30) possède au moins un trou métallisé (311) ; le dispositif de montage (10) comprenant :
une partie pénétrante (111) configurée pour traverser le trou traversant (21) de l'objet (20) et ayant deux extrémités ; la partie pénétrante (111) comprenant :
deux surfaces ;
une rainure (116) évidée sur une des surfaces de la partie pénétrante (111) ; et
une protubérance (117) dépassant de l'autre surface de la partie pénétrante (111) ;
une partie de butée (112) disposée sur une des extrémités de la partie pénétrante (111) et pouvant venir en butée d'un bord d'une ouverture du trou traversant (21) de l'objet (20) ; et
une partie de broche (113) disposée à l'autre extrémité, opposée à la partie de butée (112), de la partie pénétrante (111), la partie de broche (113) comprenant :
au moins une broche (114) configurée pour traverser le au moins un trou métallisé (311) de la carte de circuit imprimé (30) et être soudée dans le au moins un trou métallisé (311), le dispositif de montage (10) étant **caractérisé en ce que**
la rainure (116) et la protubérance (117) s'étendent jusqu'à la partie de broche (113), et la rainure (116) et la protubérance (117) correspondent l'une à l'autre en emplacement.

2. Dispositif de montage (10) selon la revendication 1, dans lequel la partie pénétrante (111), la partie de butée (112), et la partie de broche (113) sont constituées d'une bande métallique pliée.

3. Dispositif de montage (10) selon la revendication 1 ou 2, dans lequel la partie de butée (112) est une pièce plate et perpendiculaire à la partie pénétrante (111), et s'étend et dépasse en saillie d'un côté de la partie pénétrante (111).

4. Dispositif de montage (10) selon la revendication 1 ou 2, comprenant en outre :
un composant élastique (12) gainé sur la partie pénétrante (111), le composant élastique (12) ayant deux extrémités et une des deux extrémités du composant élastique (12) étant apte à repousser l'objet (20) à l'écart de la carte de circuit imprimé (30) .

5. Dispositif de montage (10) selon la revendication 4, dans lequel la partie de broche (113) comprend en outre :
deux parties de support (115) formées sur un sommet de la partie de broche (113), s'étendant vers deux directions opposées, et en butée par l'autre extrémité, opposée à l'objet (20), de l'élément élastique (12).

6. Dispositif de montage (10) selon la revendication 1 ou 2, dans lequel la partie de broche (113) comprend :
une première partie d'extension (1131) montée sur la partie pénétrante (111) et une largeur de la première partie d'extension (1131) étant supérieure à une largeur de la partie pénétrante (111); dans lequel les deux parties de support (115) sont pliées et formées au niveau de la première partie d'extension (1131);
deux deuxièmes parties d'extension (1132) pliées et formées respectivement aux deux extrémités de la première partie d'extension (1131); dans lequel le nombre d'au moins une broche (114) de la partie de broche (113) est supérieur à un, et deux d'au moins une broche (114) sont montées individuellement sur les deux deuxièmes parties d'extension (1132).

7. Procédé de montage pour monter un objet (20) sur une carte de circuit imprimé (30) comprenant les étapes suivantes de:
montage d'au moins un dispositif de montage (10) sur la carte de circuit imprimé (30), dans lequel chacun du au moins un dispositif de montage (10) comprend une partie pénétrante (111), une partie de butée (112) et une partie de broche (113), la partie de butée (112) et la partie de broche (113) sont disposées à deux extrémités opposées de la partie pénétrante (111), et la partie de broche (113) comprend au moins une broche (114) traversant le au moins un trou métallisé (311) de la carte de circuit imprimé (30) et soudée dans le au moins un trou métallisé (311); la partie pénétrante (111) comprend deux surfaces, une rainure (116) et une protubérance (117); la rainure (116) est évidée sur une des surfaces de la partie pénétrante (111); la protubérance (117) dépasse en saillie hors de l'autre surface de la partie pénétrante (111); et
passage de la partie pénétrante (111) du au moins un dispositif de montage (10) à travers un trou traversant (21) de l'objet (20), pliage de la partie de butée (112) pour venir en butée contre un bord d'une ouverture du trou traversant (21) de l'objet (20), et montage ainsi de l'objet (20) sur la carte de circuit imprimé (30) via le au moins un dispositif de montage (10), le procédé étant **caractérisé en ce que** la rainure (116) et la protubérance (117) s'étendent jusqu'à la partie de broche (113), et la rainure (116) et la protubérance (117) correspondent en emplacement l'une à l'autre.

8. Procédé de montage selon la revendication 7, dans lequel le procédé de montage comprend en outre : après que le au moins un dispositif de montage (10) est passé à travers le trou traversant (21), le pliage de la partie de butée (112) du au moins un dispositif de montage (10) avec une force horizontale jusqu'à ce que la partie de butée (112) bute contre le bord de l'ouverture du au moins un trou traversant (21) de l'objet (20).

9. Procédé de montage selon la revendication 7 ou 8, dans lequel chacun du au moins un dispositif de montage (10) comprend un composant élastique (12) poussant l'objet (20) loin de la carte de circuit imprimé (30).

10. Procédé de montage selon la revendication 7 ou 8, dans lequel le procédé de montage comprend en outre, après que au moins une broche (114) de chacun du au moins un dispositif de montage (10) est passée à travers au moins un trou métallisé (311) de la carte de circuit imprimé (30), le passage de la carte de circuit imprimé (30) à travers un four de soudure avec l'objet (20) pour souder la au moins une broche (114) dans le au moins un trou métallisé (311).
